Europäisches Patentamt

European Patent Office

Office européen des brevets

(19)

(11) Veröffentlichungsnummer : **0 063 306**
**B1**

(12) # EUROPÄISCHE PATENTSCHRIFT

(45) Veröffentlichungstag der Patentschrift :
20.02.85

(21) Anmeldenummer : 82102915.4

(22) Anmeldetag : 05.04.82

(51) Int. Cl.⁴ : **G 01 R 21/06**

(54) **Nach dem Kondensatorumladeverfahren arbeitender elektronischer Elektrizitätszähler.**

(30) Priorität : 16.04.81 DE 3115522

(43) Veröffentlichungstag der Anmeldung :
27.10.82 Patentblatt 82/43

(45) Bekanntmachung des Hinweises auf die Patenterteilung : 20.02.85 Patentblatt 85/08

(84) Benannte Vertragsstaaten :
**AT BE CH DE FR GB IT LI NL SE**

(56) Entgegenhaltungen :
**DE-A- 2 747 385**

(73) Patentinhaber : **Siemens Aktiengesellschaft**
**Berlin und München Wittelsbacherplatz 2**
**D-8000 München 2 (DE)**

(72) Erfinder : **Schwendtner, Manfred, Dipl.-Ing.**
**Gundekarstrasse 3**
**D-8501 Schwarzenbruck (DE)**
Erfinder : **Steinmüller, Günter**
**Laufamholzstrasse 65**
**D-8500 Nürnberg (DE)**

EP 0 063 306 B1

**Beschreibung**

Die Erfindung betrifft einen nach dem Kondensatorumladeverfahren arbeitenden elektronischen Elektrizitätszähler zum Erfassen des Energieverbrauchs aus mindestens einer Phase eines elektrischen Netzes, bei dem der Phase ein Multiplizierglied zugeordnet ist, dem eingangsseitig strom- und spannungsproportionale Signale zugeführt sind und die leistungsproportionalen Ausgangssignale aller Multiplizierglieder zu einem Summensignal addiert sind, das einem aus einem Integrator und einem nachgeschalteten, einen oberen und einen unteren Grenzwert vorgebenden Grenzwertglied bestehenden Quantisierer zur Bildung eines Impulszuges mit leistungsproportionaler Frequenz zugeführt ist, wobei das Summensignal jeweils bei Erreichen eines Grenzwertes umgepolt wird, so daß das Ausgangssignal des Integrators ein zwischen den beiden Grenzwerten liegendes, im wesentlichen Dreiecksform aufweisendes Signal darstellt und wobei der Impulszug über einen Frequenzteiler ein Zählwerk für den Energieverbrauch speist.

Ein derartiger Elektrizitätszähler ist aus der Zeitschrift « Technisches Messen atm », 1978, Heft 11, Seiten 407 bis 411 in Form eines Drehstromzählers oder aus der DE-OS-27 47 385, Fig. 1 und zugehörigem Text, in Form eines einphasigen Wechselstromzählers bekannt. Hierbei wird das aus der Multiplikation zusammengehöriger strom- und spannungsproportionaler Signale resultierende Produktsignal in einem Quantisierer integriert und so weiter verarbeitet, daß am Ausgang des Quantisierers ein Impulszug mit leistungsproportionaler Frequenz entsteht. Hierbei ist prinzipiell neben dem Kondensatorumladeverfahren auch das Ladungskompensationsverfahren anwendbar.

Einer der wesentlichen Vorteile des Kondensatorumladeverfahren gegenüber dem Ladungskompensationsverfahren besteht darin, daß Offsetspannungen der vorgeschalteten elektronischen Funktionselemente ohne Einfluß auf die Meßgenauigkeit bleiben. Allerdings muß bei diesem Verfahren die maximale Frequenz des Impulszuges kleiner als die Netzfrequenz sein, wenn die Fehlergrenzen — wie sie bei Präzisionszählern gefordert werden — eingehalten werden sollen. Beim Ladungskompensationsverfahren besteht diese Einschränkung nicht, so daß dieses eine höhere Ausgangsfrequenz des Impulszuges ermöglicht.

Nachteilig wirkt sich die geringe maximale Impulsfrequenz beim Kondensatorumladeverfahren bei regelungstechnischen Zwecken im Rahmen von Leistungsregelkreisen aus, da die Information über die momentane Leistung im zeitlichen Abstand zwischen zwei aufeinanderfolgenden Impulsen des Impulszuges liegt und damit für die zwischen zwei Impulsen liegende Zeitspanne keine aktuelle, für eine schnelle Leistungsregelung verwendbare Aussage über den Leistungsistwert zur Verfügung steht.

Der Erfindung liegt die Aufgabe zugrunde, einen Elektrizitätszähler der eingangs genannten Art so weiterzubilden, daß zusätzlich zu dem vom Quantisierer abgegebenen Impulszug an einem Meßausgang ein weiterer Impulszug mit ebenfalls leistungsproportionaler, jedoch erheblich höherer Frequenz zur Verfügung steht.

Die Aufgabe wird erfindungsgemäß dadurch gelöst, daß eine Impulsvervielfachungsschaltung vorgesehen ist, die einen Spannungskomparator zum Vergleich des Ausgangssignals des Integrators mit mehreren, zwischen den Grenzwerten liegenden Schwellwertspannungen, die untereinander bezüglich des Spannungspegels äquidistant sind, aufweist, wobei der Spannungskomparator jeweils dann ein Ausgangssignal liefert, wenn das Ausgangssignal des Integrators eine der Schwellwertspannungen erreicht. Die Zahl der zusätzlichen Impulse entspricht der Zahl der zwischen den Grenzwerten liegenden Schwellwertspannungen. Der Spannungskomparator kann hierbei aus mehreren Einzelkomparatoren bestehen, in denen jeweils eine sich von allen anderen Schwellwertspannungen unterscheidende Schwellwertspannung mit dem Ausgangssignal des Integrators verglichen wird. Die zusätzlichen Impulse entstehen sowohl während der Anstiegszeit des im wesentlichen Dreiecksform aufweisenden Ausgangssignals des Integrators als auch während der Abstiegszeit dieses Ausgangssignals. Die untereinander bezüglich des Spannungspegels äquidistanten Schwellwertspannungen sind relativ zu den Extremwerten des im wesentlichen Dreiecksform aufweisenden Ausgangssignals des Integrators so angeordnet, daß die niedrigste Schwellwertspannung um die halbe Differenz zwischen zwei aufeinanderfolgenden Schwellwertspannungen über dem Minimum des Ausgangssignals des Integrators und die höchste Schwellwertspannung um die Hälfte der Differenz zwischen zwei aufeinanderfolgenden Schwellwertspannungen unterhalb des Maximums dieses Signals zu liegen kommt. Damit ist gewährleistet, daß bei konstanter Leistungsentnahme aus dem elektrischen Netz alle Ausgangsimpulse des Spannungskomparators untereinander einen gleichen zeitlichen Abstand aufweisen.

Eine bevorzugte Ausführungsform der Erfindung besteht darin, daß die Impulsvervielfacherschaltung einen Schwellwertspannungsgeber aufweist, der an den einen Vergleichseingang des Spannungskomparators angeschlossen ist, dessen anderer Vergleichseingang mit dem Ausgang des Integrators verbunden ist, wobei jeweils bei Gleichheit der an den Vergleichseingängen anstehenden Spannungen durch den Schwellwertspannungsgeber die jeweils nächstfolgende Schwellwertspannung vorgegeben wird. In diesem Fall wird für den Spannungskomparator nur ein einziges Vergleichsglied benötigt. Als Schwellwertspannungsgeber kann ein durch das Ausgangssignal des Spannungskomparators triggerbarer Treppenspannungsgenerator dienen.

Bei einer bevorzugten Ausführungsform dient als Schwellwertspannungsgeber ein umschaltbarer Vor-Rückwärts-Zähler, dessen Zähleingang mit dem Ausgang des Spannungskomparators und dessen Binärausgänge über ein R/2R-Netzwerk mit dem einen Vergleichseingang des Spannungskomparators verbunden sind, wobei der Umschalteingang des Vor-Rückwärts-Zählers mit dem Ausgang des Grenzwertgliedes verbunden ist. Dies stellt einen sehr eleganten und außerordentlich aufwandsarmen Schwellwertspannungsgeber dar. Durch das an die Binärausgänge des Vor-Rückwärts-Zählers angeschlossene R/2R-Netzwerk entsteht am Vergleichseingang des Spannungskomparators ein stufenweise dem Zählerstand entsprechendes Analogsignal, dessen Spannungspegel jeweils bei Eingang eines Impulses am Zähleingang des Vor-Rückwärts-Zähler in untereinander gleichen Stufen erhöht wird.

Eine vorteilhafte Weiterbildung der Erfindung besteht darin, daß der Vor-Rückwärts-Zähler jeweils dann, wenn das Ausgangssignal des Integrators den unteren Grenzwert des Grenzwertgliedes erreicht, auf Null zurückgesetzt wird, und jeweils dann, wenn das Ausgangssignal des Integrators den oberen Grenzwert des Grenzwertgliedes erreicht, auf den höchsten Zählwert gesetzt wird. Damit werden für jede Halbperiode des im wesentlichen Dreiecksform aufweisenden Ausgangssignales des Integrators definierte Anfangsbedingungen für die Schwellwertspannungen geschaffen.

Zur Ableitung der den Vor-Rückwärts-Zähler setzenden bzw. rücksetzenden Signale kann der Ausgang des Grenzwertgliedes über ein Differenzierglied mit dem Rücksetzeingang und über ein Invertierglied sowie ein nachgeschaltetes Differenzierglied mit dem Setzeingang des Vor-Rückwärts-Zählers verbunden sein.

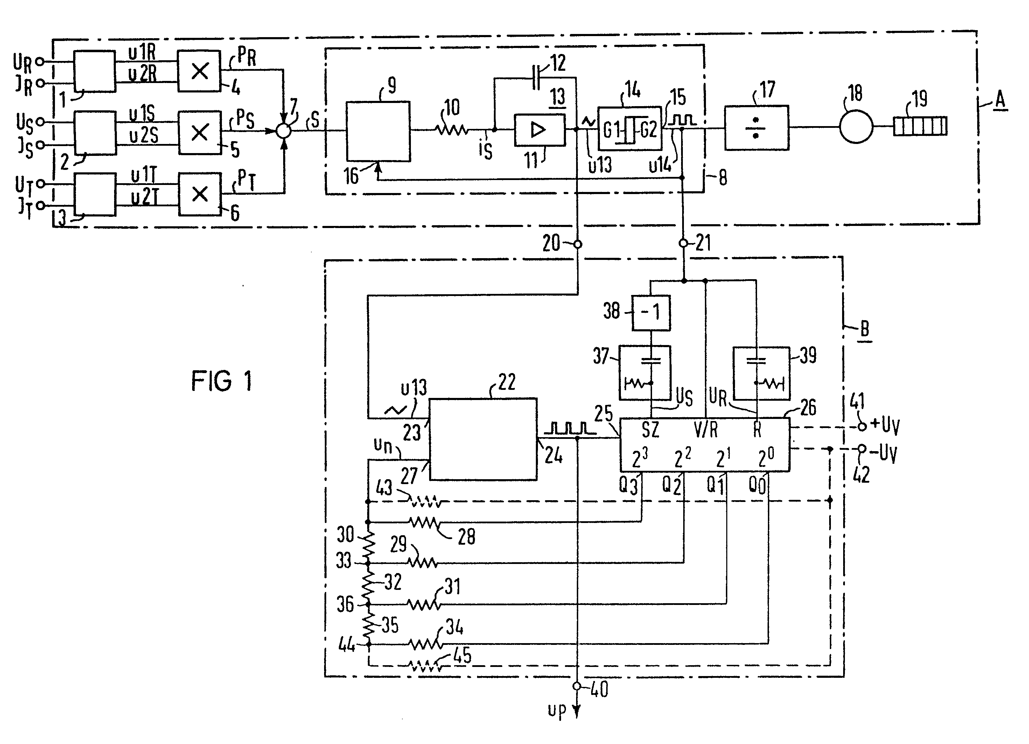

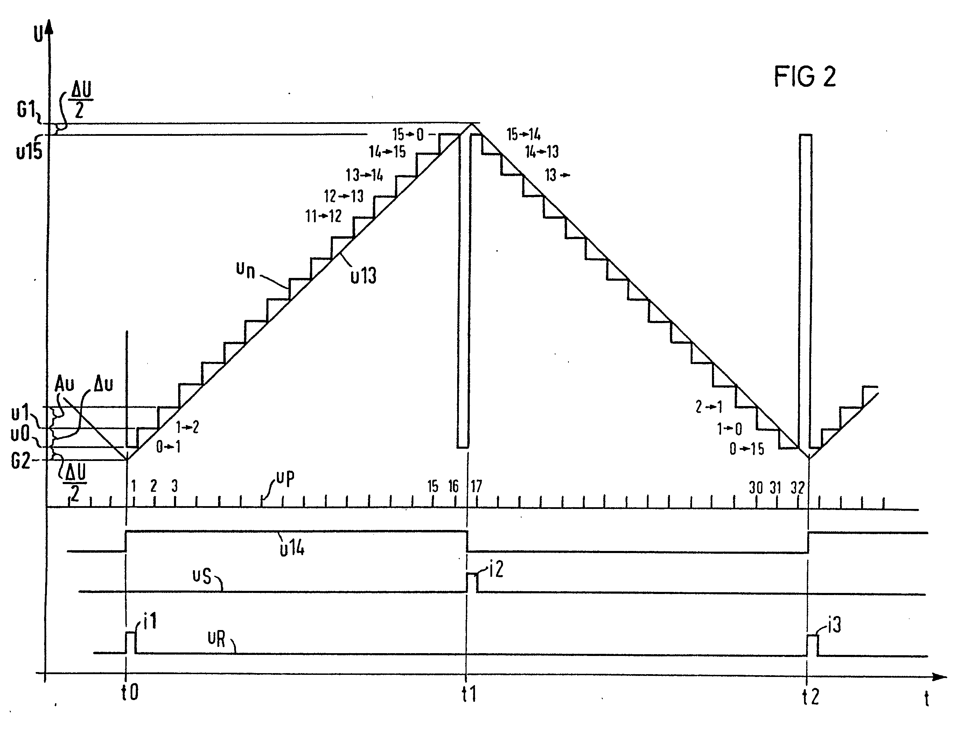

Im folgenden wird die Erfindung anhand eines Ausführungsbeispiels in den Figuren 1 und 2 näher erläutert. Dabei zeigt :

Figur 1 einen nach dem Kondensatorumladeverfahren arbeitenden elektronischen Elektrizitätszähler mit einer erfindungsgemäßen Impulsvervielfacherschaltung und

Figur 2 ein Impulsdiagramm zur Erläuterung der Funktion der Impulsvervielfacherschaltung.

Der in dem gestrichelt eingezeichneten und mit A bezeichneten Rechteck enthaltene Schaltungsteil zeigt einen nach dem Kondensatorumladeverfahren arbeitenden Elektrizitätszähler, wie er aus der eingangs erwähnten Zeitschrift « Technisches Messen atm », 1978, Heft 11, Seiten 407 bis 411 bekannt ist. Hierbei handelt es sich um einen Drehstromzähler. Die den elektrischen Energieverbrauch im Drehstromnetz charakterisierenden Strom- und Spannungswerte $U_R$, $I_R$, $U_S$, $I_S$, $U_T$ und $I_T$ werden in den Wandlern 1 bis 3 in proportionale Spannungssignale u1R, u2R, u1S, u2S, u1T und u2T gewandelt. Die jeweils einer Phase zugehörigen Signale, also beispielsweise die der Netzphase R zugehörigen spannungs- und stromproportionalen Signale u1R und u2R, werden in den Multipliziergliedern 4 bis 6 zu den leistungsproportionalen Signalen $P_R$, $P_S$ und $P_T$ verarbeitet. Als Multiplizierglieder 4 bis 6 dienen vorzugsweise Time-Division-Multiplizierer. Die die entnommene elektrische Leistung noch in den einzelnen Netzphasen R, S und T charakterisierenden Signale $P_R$, $P_S$ und $P_T$ sind pulsierende Spannungen, deren zeitlicher Mittelwert proportional zu der den einzelnen Netzphasen entnommenen elektrischen Leistungen ist. In dem Addierglied 7 werden die Signale $P_R$, $P_S$ und $P_T$ zu dem Summensignal S aufsummiert.

Im Falle eines einphasigen elektronischen Elektrizitätszählers, also eines Wechselstromzählers, ist nur ein Wandler und ein Multiplizierglied, also beispielsweise im Fall der Netzphase R der Wandler 1 und das Multiplizierglied 4, nötig. Das Addierglied 7 entfällt, so daß in diesem Fall das Signal $P_R$ und das Summensignal S übereinstimmen.

Das Summensignal S ist dem Eingang des Quantisierers 8 zugeführt. Der Quantisierer 8 weist eingangsseitig einen steuerbaren Polaritätsumschalter 9 für das Summensignal, einen nachgeschalteten Widerstand 10 und einen aus einem Verstärker 11 und einem der Verstärker überbrückenden Integrationskondensator 12 bestehenden Integrator 13 sowie ein nachgeschaltetes Grenzwertglied 14 auf, wobei der Ausgang 15 des Grenzwertgliedes 14 den Ausgang des Quantisierers 8 bildet. Der Ausgang 15 des Grenzwertgliedes 14 ist darüber hinaus mit dem Steuereingang 16 des Polaritätsumschalters 9 verbunden.

Das Summensignal S wird in der einen Stellung des Polaritätsumschalters 9 nach Wandlung in einen Strom $i_S$ im Integrator 13 aufintegriert, bis das Ausgangssignal u13 des Integrators 13 den oberen Grenzwert des Grenzwertgliedes 14 erreicht. In diesem Augenblick tritt ein Signalwechsel am Ausgang 15 des Grenzwertgliedes 14 auf, durch den am Steuereingang 16 des Polaritätsumschalters 9 die Polarität des Summensignals S am Ausgang des Polaritätsumschalters geändert wird. Damit fließt der Strom $i_S$ am Eingang des Integrators 13 nunmehr in Gegenrichtung, so daß das Ausgangssignal u13 nunmehr absinkt, bis der untere Grenzwert G2 des Grenzwertgliedes 14 erreicht ist, worauf ein erneuter Signalwechsel am Ausgang 15 erfolgt. Durch diesen erneuten Signalwechsel wird am Steuereingang 16 des Polaritätsumschalters die ursprüngliche Polarität wieder hergestellt. Das Signal u13 am Ausgang des Integrators 13 weist daher im wesentlichen Dreiecksform auf und bewegt sich zwischen dem oberen Grenzwert G1 und dem unteren Grenzwert G2. Am Ausgang des Quantisierers 8 entsteht somit ein Impulszug u14 mit leistungsproportionaler Frequenz. Dieser Impulszug u14 wird im Frequenzteiler 17 soweit untersetzt, daß über einen Schrittmotor 18 ein Rollenzählwerk 19 betätigt werden kann. Das Rollenzählwerk 19 zeigt die den drei Netzphasen R, S und T von einem Verbraucher entnommene elektrische Energie an.

Ein Ausführungsbeispiel der erfindungsgemäßen Impulsvervielfacherschaltung ist in Fig. 1 mit B bezeichnet. Die Impulsvervielfacherschaltung B weist die Eingangsklemmen 20 und 21 auf, wobei an ersterer das Ausgangssignal u13 des Integrators 13 und an letzterer das Ausgangssignal u14 des Grenzwertgliedes 14 ansteht. Die Impulsvervielfacherschaltung B enthält einen Spannungskomparator 22, an dessen einem Eingang 23 das an der Eingangsklemme 20 anstehende Signal u13 geführt ist. Der Ausgang 24 des Spannungskomparators 22 ist mit dem Zähleingang 25 eines Vor-Rückwärts-Zählers 26 verbunden Der Vor-Rückwärts-Zähler 26 weist im Ausführungsbeispiel vier Binärausgänge $Q_0$, $Q_1$, $Q_2$ und $Q_3$ mit den Wertigkeiten $2^0$, $2^1$, $2^2$ und $2^3$ auf. Damit kann der Vor-Rückwärts-Zähler 26 maximal 16 Impulse zählen und in binärer Form an seinen Binärausgängen $Q_0$ bis $Q_3$ ausgeben.

Die Binärausgänge $Q_0$ bis $Q_3$ sind über ein an sich bekanntes R/2R-Netzwerk mit dem anderen Eingang 27 des Spannungskomparators 22 verbunden. Hierbei ist der Binärausgang $Q_3$ über den Widerstand 28 an den anderen Eingang 27 des Spannungskomparators 22 angeschlossen. Der Binärausgang $Q_2$ ist über die Serienschaltung der Widerstände 29 und 30 an den anderen Eingang 27 angeschlossen. Der Binärausgang $Q_1$ ist über die Serienschaltung der Widerstände 31 und 32 an den Verbindungspunkt 33 der Widerstände 29 und 30 angeschlossen. Der Binärausgang $Q_0$ ist über die Serienschaltung der Widerstände 34 und 35 an den Verbindungspunkt 36 der Widerstände 31 und 32 angeschlossen. Dabei weisen die Widerstände 28, 29, 31 und 34 gleichen Widerstandswert auf, der doppelt so groß ist, wie der Widerstandswert der Widerstände 30, 32 und 35, die ebenfalls untereinander gleichgroße Widerstandswerte aufweisen. Die Widerstände 28, 29, 31 und 34 können beispielsweise einen Widerstandswert von 200 kOhm besitzen, wohingegen die Widerstände 30, 32 und 35 einen Widerstandswert von 100 kOhm aufweisen. Durch dieses R2/R2-Netzwerk entsteht am anderen Eingang 27 ein analoges Spannungssignal $u_n$, dessen Wert stufenweise proportional zum Inhalt des Vor-Rückwärts-Zählers 26 ist. Durchläuft der Vor-Rückwärts-Zähler 26 die Zahlenwerte zwischen 0 bis 15 in zeitlicher Folge, dann nimmt die Spannung $u_n$ einen treppenförmigen Verlauf an.

Der Vor-Rückwärts-Zähler 26 ist bezüglich seiner Zählrichtung über den Eingang V/R in dem Sinn steuerbar, daß — wenn das an diesem Steuereingang V/R geführte Signal u14 H-Pegel aufweist — der Vor-Rückwärts-Zähler 26 die an seinem Zähleingang 25 anstehenden Impulse aufwärts zählt und daß — wenn das Signal u14 L-Pegel aufweist — eine Abwärts- oder Rückwärtszählung stattfindet. Darüber hinaus weist der Vor-Rückwärts-Zähler 26 einen Setzeingang SZ auf.

Tritt an diesen Setzeingang SZ ein geeigneter Impuls auf, dann wird der maximale Zählerstand von 15 am Vor-Rückwärts-Zähler 26 eingestellt, bei dem alle Binärausgänge $Q_0$ bis $Q_3$ H-Pegel aufweisen. Darüber hinaus weist der Vor-Rückwärts-Zähler 26 einen Rücksetzeingang R auf, durch den bei Eingang eines geeigneten Impulses der Zählerstand 0 und damit L-Pegel an allen Binärausgängen $Q_0$ bis $Q_3$ erzwungen wird. Zur Ableitung eines Setzimpulses ist der Setzeingang SZ über ein Differenzierglied 37 sowie ein Invertierglied 38 mit der Eingangsklemme 21 verbunden. Zur Gewinnung eines Rücksetzsignals ist der Rücksetzeingang R des Vor-Rückwärts-Zählers 26 über ein Differenzierglied 39 ebenfalls mit der Eingangsklemme 21 verbunden. Damit werden sowohl das am Steuereingang V/R anstehende Zählrichtungssignal als auch das Setz- bzw. Rücksetzsignal aus dem Signal u14 abgeleitet.

Die Ausgangsklemme der Impulsvervielfacherschaltung B ist mit dem Bezugszeichen 40 versehen und an den Ausgang 24 des Spannungskomparators 22 angeschlossen. Dieses Ausgangssignal $u_P$ besteht aus einzelnen Impulsen, wobei zwischen jeweils zwei Signalen des Signals u14 jeweils 32 derartige Impulse auftreten. Damit ist gegenüber dem Ausgangssignal u14 des Quantisierers 8 eine Verzweiunddreissigfachung der Frequenz erreicht.

Der Vor-Rückwärts-Zähler 26 kann als C-MOS-Schaltkreis ausgeführt sein. In diesem Fall wird die positive und negative Versorgungsspannung $+ U_V$ und $- U_V$ — wie in Fig. 1 gestrichelt eingezeichnet — über die Klemmen 41 und 42 zugeführt. Wenn das im wesentlichen Dreiecksform aufweisende Signal u13 symmetrisch zum Spannungs-Nullpunkt zwischen einem positiven oberen Grenzwert G1 und einem betragsmäßig gleichgroßen negativen unteren Grenzwert G2 schwankt, kann die erforderliche Verschiebung der Spannung $u_n$ des R/2R-Netzwerks zu negativen Spannungen in einfacher Weise dadurch erfolgen, daß der Eingang 27 des Spannungskomparators 22 über einen Widerstand 43 mit der die negative Versorgungsspannung-$U_V$ führenden Klemme 42 verbunden ist und darüber hinaus der Verbindungspunkt 44 der Widerstände 34 und 35 über einen weiteren Widerstand 45 ebenfalls an die Klemme 42 angeschlossen ist. Dies ist in Fig. 1 gestrichelt eingezeichnet.

Der Spannungskomparator 22 kann durch einen eingangsseitigen Operationsverstärker sowie eine nachgeschaltete Impulsformerschaltung realisiert sein, wobei die Impulsformerschaltung aus jedem, bei Gleichheit der Spannungen u13 und $u_n$ am Eingang des Spannungskomparators 22 bzw. des eingangsseitigen Operationsverstärkers im Spannungskomparator 22 auftretenden Signalwechsel einen zum Ansteuern des Zähleingangs 25 des Vor-Rückwärts-Zählers 26 geeigneten Impuls herleitet.

Das in Fig. 2 dargestellte Impulsdiagramm veranschaulicht die Wirkungsweise der Impulsvervielfacherschaltung B. Das am Ausgang 15 des Grenzwertgliedes 14 auftretende Signal u14 in Form eines Impulszuges aus Rechtecksignalen, dessen Frequenz der den drei Netzphasen R, S, T entnommenen Leistung proportional ist, ist in Zeile 3 der Fig. 2 dargestellt. In Zeile 1 der Fig. 2 ist das im wesentlichen Dreiecksform aufweisende Signal u13 am Ausgang des Integrators 13 dargestellt. Das Signal u13 bewegt sich zwischen den durch das Grenzwertglied 14 vorgegebenen Grenzwerten G1 und G2, wobei die zu den Zeitpunkten t0, t1 und t2 auftretende Extrema des Signals u13 natürlich zeitlich mit dem Signalwechsel des Signals u14 zusammenfallen. Aus der ansteigenden Flanke des Signals u14 wird im Zeitpunkt t0 durch das Differenzierglied 39 ein Impuls i1 des am Rückstelleingang R des Vor-Rückwärts-Zählers 26 anstehenden Signals $u_R$ gewonnen, wodurch der Vor-Rückwärts-Zähler 26 auf den Wert 0 gesetzt wird. Dem Wert 0 des Vor-Rückwärts-Zählers 26 entspricht der ausgangsseitige Spannungswert $u_0$ des vom R/R2-Netzwerks gelieferten Signals $u_n$ am anderen Eingang des Spannungskomparators 22. Der Spannungswert $u_0$ liegt um Δu/2 über dem dem unteren Grenzwert G2 entsprechenden Minimum des Ausgangssignals u13 des Integrators 13. Sobald das ansteigende Signal u13 den Spannungswert $u_0$ erreicht, entsteht am Ausgang 24 des Spannungskomparators 22 der Impuls 1 des in Zeile 2 der Fig. 2 dargestellten Impulszuges $u_P$. Dieser Impuls 1 erscheint am Ausgang 40 der Impulsvervielfacherschaltung B und bewirkt gleichzeitig über den Zähleingang 25 des Vor-Rückwärts-Zählers 26 das Weiterschalten auf den Wert 1. Die vorerwähnte Spannungsdifferenz Δu entspricht der Höhe einer der untereinander sich um diese Spannungsdifferenz Δu unterscheidenden Spannungsstufen des Signals $u_n$. Damit tritt am Binärausgang $Q_0$ des Vor-Rückwärts-Zählers 26 ein Signalwechsel von L-Pegel auf H-Pegel auf, woraus über das R/2R-Netzwerk das am Eingang 27 des Spannungskomparators 22 anstehende Signal $u_n$ um den Wert Δu auf den Spannungswert $u_1$ angehoben wird. Da das Signal u13 kontinuierlich ansteigt, wird dieses schließlich auch den Wert u1 erreichen, worauf der Impuls 2 des Impulszuges $u_P$ entsteht, das den Inhalt des Vor-Rückwärts-Zählers 26 auf den Wert 2 erhöht. Dieser Wirkungsablauf wiederholt sich nun bis schließlich der Vor-Rückwärts-Zähler 26 einen Maximalinhalt von 15 erreicht, worauf das Signal $u_n$ den Spannungswert $u_{15}$ annimmt. Sobald das Signal u13 diesen Spannungswert u15 erreicht hat, setzt der dabei am Ausgang 24 des Spannungskomparators 22 entstehende nächste Impuls den Vor-Rückwärts-Zähler 26 auf den Wert 0. Das Signal $u_n$ fällt damit auf den Spannungswert $u_0$ zurück. Der Wert u15 liegt um Δu/2 niedriger als das zum Zeitpunkt t1 auftretende Maximum des dreieckförmigen Signals u13. In diesem Zeitpunkt t1 wird aus der abfallenden Flanke des in Zeile 3, Fig. 2 dargestellten Signals u14 über das Invertierglied 38 und das Differenzierglied 37 ein Impuls i2 des am Setzeingang SZ des Vor-Rückwärts-Zählers 26

anstehenden Signalzuges $U_S$ hergeleitet. Dadurch wird der Vor-Rückwärts-Zähler 26 auf seinen Maximalwert von 15 gesetzt, was am Eingang 27 des Spannungskomparators 22 die erneute Anhebung des Signals $u_n$ auf den Spannungswert u15 bewirkt. Da die Spannung des Signals u13 nunmehr abnimmt, tritt dann, wenn das Signal u13 den Spannungswert u15 erreicht, der mit 17 bezeichnete Impuls des Impulszuges $u_P$ auf. Da das Signal u14 nach Erreichen des oberen Grenzwertes G1 aud L-Pegel abgefallen ist, ist nunmehr der Vor-Rückwärts-Zähler 26 über den Zählrichtungseingang V/R auf « Abwärtszählung » umgestellt. Damit bewirkt der Impuls 17 des Impulszuges $u_P$ die Verringerung des Inhaltes des Vor-Rückwärts-Zählers 26 auf den Wert 14. Dies zieht eine entsprechende Verringerung des Signals $u_n$ nach sich. Dies setzt sich nun stufenweise fort, bis der Vor-Rückwärts-Zähler 26 wieder den Wert 0 aufweist. Durch den Impuls 32 des Impulszuges $u_P$ wird durch den nächsten am Zähleingang 25 des Vor-Rückwärts-Zählers 26 eingehenden Impuls dieser auf den Wert 15 « Hochgezählt ». Aus der ansteigenden Flanke des Signals u14 wird nunmehr im Zeitpunkt t2 wiederum über das Differenzierglied 39 ein Impuls i3 des am Eingang R des Vor-Rückwärts-Zählers 26 anstehenden Signals $u_R$ erzeugt, wodurch der Vor-Rückwärts-Zähler 26 auf den Wert 0 zurückgesetzt wird, worauf das Signal $u_n$ wieder auf den Spannungspegel $u_0$ zurückfällt. Damit kann ein neuer Arbeitszyklus der Impulsvervielfacherschaltung 2 beginnen. Damit treten nunmehr durch die Wirkung der Impulsvervielfacherschaltung B in der Zeitspanne t2-t0 zwischen zwei Minima des Signals u13 32 Impulse des Impulszuges $u_P$ am Ausgang 40 auf. Das bedeutet gegenüber dem einzigen Impuls u14 in dieser Zeitspanne t2-t0 eine Verzweiunddreissigfachung der leistungsproportionalen Frequenz.

Durch Verwendung eines Vor-Rückwärts-Zählers mit größerem oder kleinerem maximalen Speicherinhalt kann eine entsprechende Vergrößerung bzw. Verkleinerung der in diese Zeitspanne fallenden Impulszahl am Ausgang 40 der Impulsvervielfacherschaltung erreicht werden.

**Ansprüche**

1. Nach dem Kondensatorumladeverfahren arbeitender elektronischer Elektrizitätszähler zum Erfassen des Energieverbrauchs aus mindestens einer Phase eines elektrischen Netzes, bei dem der Phase ein Multiplizierglied (4, 5, 6) zugeordnet ist, dem eingangsseitig strom- und spannungsproportionale Signale zugeführt sind und die leistungsproportionalen Ausgangssignale aller Multiplizierglieder zu einem Summensignal (5) addiert sind, das einem aus einem Integrator (13) und einem nachgeschalteten, einen oberen und einen unteren Grenzwert vorgebenden Grenzwertglied (14) bestehenden Quantisierer (8) zur Bildung eines Impulszuges (u14) mit leistungsproportionaler Frequenz zugeführt ist, wobei das Summensignal jeweils bei Erreichen eines Grenzwertes umgepolt wird, so daß das Ausgangssignal (u13) des Integrators ein zwischen den beiden Grenzwerten liegendes, im wesentlichen Dreiecksform aufweisendes Signal darstellt und wobei der Impulszug über einen Frequenzteiler (17) ein Zählwerk (19) für den Energieverbrauch speist, dadurch gekennzeichnet, daß eine Impulsvervielfacherschaltung (B) vorgesehen ist, die einen Spannungskomparator (22) zum Vergleich des Ausgangssignals (u13) des Integrators (13) mit mehreren, zwischen den Grenzwerten (G1, G2) liegenden Schwellwertspannungen (u_n), die untereinander bezüglich des Spannungspegels äquidistant (Δu) sind, aufweist, wobei der Spannungskomparator (22) jeweils dann einen Ausgangsimpuls (1, 2, ..., 32 ; u_P) liefert, wenn das Ausgangssignal (u13) des Integrators (13) eine der Schwellwertspannungen (u0, u1, u15) erreicht.

2. Elektrizitätszähler nach Anspruch 1, dadurch gekennzeichnet, daß die Impulsvervielfacherschaltung (B) einen Schwellwertspannungsgeber (26, 28-32, 34, 35) aufweist, der an den einen Vergleichseingang (27) des Spannungskomparators (22) angeschlossen ist, dessen anderer Vergleichseingang (23) mit dem Ausgang (u13) des Integrators (13) verbunden ist, wobei jeweils bei Gleichheit der an den Vergleichseingängen (23, 27) anstehenden Spannungen (u13, u_n) durch den Schwellwertspannungsgeber (26 bis 32, 34, 35) die jeweils nächstfolgende Schwellwertspannung (u0, u1, u15) vorgegeben wird.

3. Elektrizitätszähler nach Anspruch 2, dadurch gekennzeichnet, daß als Schwellwertspannungsgeber ein zählrichtungsumschaltbarer Vor-Rückwärts-Zähler (26) dient, dessen Zähleingang (25) mit dem Ausgang des Spannungskomparators (22) und dessen Binärausgänge (Q0, Q1, Q2, Q3) über ein R/R2-Netzwerk (28 bis 32, 34, 35) mit dem einen Vergleichseingang (27) des Spannungskomparators (22) verbunden ist, wobei der Zählrichtungsumschalteingang (V/R) des Vor-Rückwärts-Zählers (26) mit dem Ausgang (15) des Grenzwertgliedes (14) verbunden ist.

4. Elektrizitätszähler nach Anspruch 3, dadurch gekennzeichnet, daß der Vor-Rückwärts-Zähler (26) jeweils dann, wenn das Ausgangssignal (u13) des Integrators (13) den unteren Grenzwert (G2) des Grenzwertgliedes (14) erreicht auf 0 zurückgesetzt wird und jeweils dann, wenn das Ausgangssignal (u13) des Integrators (13) den oberen Grenzwert (G1) des Grenzwertgliedes (14) erreicht, auf den höchsten Zählwert gesetzt wird.

5. Elektrizitätszähler nach Anspruch 4, dadurch gekennzeichnet, daß der Ausgang des Grenzwertgliedes (14) über ein Differenzierglied (39) mit dem Rücksetzeingang (R) und über ein Invertierglied (38) sowie ein nachgeschaltetes Differenzierglied (37) mit dem Setzeingang (SZ) des Vor-Rückwärts-Zählers (26) verbunden ist.

## Claims

1. An electronic electricity meter which operates in accordance with the capacitor charge exchange method for detecting the energy consumption from at least one phase of an electric network, wherein the phase is assigned a multiplier element (4, 5, 6) supplied at its input with signals proportional to current and voltage, and the power-proportional output signals of all the multipliers are added to form a sum signal (S) fed to a quantizer (8) which consists of an integrator (13) and a following limit value element (14), which imposes an upper and a lower limit value, in order to form a pulse train (u14) with a power-proportional frequency, where, whenever a limit value is reached, the sum signal is reversed in polarity so that the output signal (u13) of the integrator represents a signal which is located between the two limit values and is fundamentally triangular, and where, via a frequency divider (17), the pulse train feeds a metering unit (19) for the energy consumption, characterised in that a pulse multiplier circuit (B) is provided which possesses a voltage comparator (22) which serves to compare the output signal (u13) of the integrator (13) with a plurality of threshold value voltages (u_n) which are located between the limit values (G1, G2) and are equidistant (Δu) from one another in respect of the voltage level, and where the voltage comparator (22) supplies an output pulse (1, 2, ..., 32 ; u_P) whenever the output signal (u13) of the integrator (13) reaches one of the threshold value voltages (u0, u1, u15).

2. An electricity meter as claimed in Claim 1, characterised in that the pulse multiplier circuit (B) possesses a threshold value voltage generator (26, 28-32, 34, 35) which is connected to the first comparison input (27) of the voltage comparator (22), whose other comparison input (23) is connected to the output (u13) of the integrator (13), and whenever there is identity between the voltages (u13, u_n) occurring at the comparison inputs (23, 27) the next threshold value voltage (u0, u1, u15) is imposed by the threshold value voltage generator (26-32, 34, 35).

3. An electricity meter as claimed in Claim 2, characterised in that the threshold value voltage generator consists of a forwards-backwards counter (26) which can have its couting direction switched over, whose counting input (25) is connected to the output of the voltage comparator (22) and whose binary outputs (Q0, Q1, Q2, Q3) are connected via a R/R2-network (28-32, 34, 35) to the first comparison input (27) of the voltage comparator (22), where the counting-direction/switch-over input (V/R) of the forwards-backwards counter (26) is connected to the output (15) of the limit value element (14).

4. An electricity meter as claimed in Claim 3, characterised in that whenever the output signal (u13) of the integrator (13) reaches the lower limit value (G2) of the limit value element (14), the forwards-backwards counter (26) is reset to zero, and whenever the output signal (u13) of the integrator (13) reaches the upper limit value (G1) of the limit value element (14), the forwards-backwards counter (26) is set at the highest counting value.

5. An electricity meter as claimed in Claim 4, characterised in that the output of the limit value element (14) is connected via a differentiator (39) to the reset input (R) and is connected via an inverter (38) and a following differentiator (37) to the set input (SZ) of the forwards-backwards counter (26).

## Revendications

1. Compteur électrique électronique opérant selon le procédé à inversion de charges d'un condensateur, en vue de saisir la consommation d'énergie à partir d'au moins une phase d'un réseau électrique, dans lequel on associe à la phase un dispositif multiplicateur (4, 5, 6) auquel on applique, du côté entrée, des signaux qui sont proportionnels au courant et à la tension alors que les signaux de sortie de tous les dispositifs multiplicateurs, et qui sont proportionnels à la puissance, sont additionnées pour former un signal de sommation (S) qui est appliqué à un quantificateur qui est constitué par un intégrateur (13) et par un dispositif à valeur limite (14) monté en aval et donnant à l'avance une valeur-limite supérieure et une valeur-limite inférieure, en vue de former un train d'impulsions (u14) de fréquence qui est proportionnelle à la puissance, la réalisation étant telle que la polarité du signal de sommation est inversée toutes les fois qu'une valeur-limite est atteinte, de façon que le signal de sortie (u13) de l'intégrateur représente un signal qui se situe entre les deux valeurs-limites et de forme sensiblement triangulaire, le train d'impulsions alimentant, par l'intermédiaire d'un diviseur de fréquences (17) un dispositif de comptage (19) pour la consommation d'énergie, caractérisé par le fait qu'il est prévu un circuit multiplicateur des impulsions (B) comportant un comparateur de tension (22) pour comparer le signal de sortie (u13) de l'intégrateur (13) avec plusieurs tensions à valeur de seuil ($u_n$) qui se situent entre les valeurs-limites (G1, G2) et qui sont équidistantes ($\Delta u$) entre elles du point de vue du niveau de la tension, le comparateur de tension (22) fournissant alors une impulsion de sortie (1, 2, ..., 32 ; $u_P$) toutes les fois que le signal de sortie (u13) de l'intégrateur (13) atteint l'une des tensions à valeur de seuil (u0, u1, u15).

2. Compteur d'électricité selon la revendication 1, caractérisé par le fait que le circuit multiplicateur des impulsions (B) comporte un générateur de tension à valeur de seuil (26, 28-32, 34, 35) qui est relié à l'entrée de comparaison (26) du comparateur de tensions (22), dont l'autre entrée de comparaison (23) est reliée à la sortie (u13) de l'intégrateur (13), étant noté que dans le cas d'une identité des tensions (u13, $u_n$) qui sont présentes au niveau des entrées de comparaison (23, 27), la tension de valeurs de seuil suivante (u0, u1, u15) est donnée à l'avance par le générateur de tensions à valeur de seuil (26 à 32, 34, 35).

3. Compteur d'électricité selon la revendication 2, caractérisé par le fait qu'il est prévu, en tant que générateur de valeur de seuil, un compteur décompteur (26) à sens commutable, dont l'entrée de comptage (25) est reliée à la sortie du comparateur de tensions (22) et dont les sorties binaires (Q0, Q1, Q2, Q3) sont reliées, par l'intermédiaire d'un réseau R/R2 (28 à 32, 34, 35), à une première entrée de comparaison (27) du comparateur de tensions (22), la réalisation étant telle que l'entrée d'inversion du sens de comptage (V/R) du compteur-décompteur (26) est reliée à la sortie (15) du dispositif à valeur-limite (14).

4. Compteur électrique selon la revendication 3, caractérisé par le fait que le compteur-décompteur (26) est ramené à 0 toutes les fois que le signal de sortie (u13) de l'intégrateur (13) a atteint la valeur-limite inférieure (G2) du dispositif à valeur-limite (14) et est amené à la valeur de comptage la plus élevée lorsque le signal de sortie (u13) de l'intégrateur (13) atteint la valeur-limite supérieure (G1) du dispositif à valeur-limite (14).

5. Compteur électrique selon la revendication 4, caractérisé par le fait que la sortie du dispositif à valeur-limite (14) est reliée, par l'intermédiaire d'un dispositif de différenciation (39), à l'entrée de remise à l'état initial (R) et par l'intermédiaire d'un dispositif inverseur (38) ainsi que par l'intermédiaire d'un dispositif différenciateur amont (37), à l'entrée de commande (SZ) du compteur-décompteur (26).

FIG 1

0 063 306

FIG 2

0 063 306